# EUROPEAN PATENT APPLICATION

(11) **EP 4 749 377 A1**
(43) Date of publication of application: **27.05.2026**
(21) Application number: 25215231.9
(22) Date of filing: 12.11.2025
(51) Int. Cl.: G03G 21/20, B41J 29/377

(54) **IMAGE FORMING APPARATUS**

(30) Priority: 22.11.2024 JP 2024203830
(71) Applicant: KYOCERA Document Solutions Inc., Osaka-shi, Osaka 540-8585 (JP)
(72) Inventor: Yamaguchi, Akihiro, Osaka-shi, 540-8585 (JP)
(74) Representative: Plougmann Vingtoft a/s

(57) **Abstract**

A printing device (4) is disposed above a sheet storing portion (2). A heat exchange unit (6b) is disposed adjacent to a cooling target, which is a part of the printing device (4), and exchanges heat between the cooling target and refrigerant liquid. A heat exchange area tray (60) is disposed in an area spanning the entire heat exchange unit (6b) in plan view between the sheet storing portion (2) and the heat exchange unit (6b), and can receive liquid falling from above.

## Description

### INCORPORATION BY REFERENCE

This application is based upon and claims the benefit of priority from the corresponding Japanese Patent Application No. 2024-203830 filed on November 22, 2024.

### BACKGROUND

The present disclosure relates to an image forming apparatus including a liquid cooling type cooling device.

Devices constituting the image forming apparatus tend to become hot due to the high speed of the printing process.

For example, in an electrophotographic image forming apparatus, toner stored in a developing device may become hot due to frictional heat generated by stirring of the toner. If the toner temperature rises, the softened toner may agglomerate, resulting in poor image quality.

Therefore, the image forming apparatus may be provided with a cooling device. For example, it is known that an electrophotographic image forming apparatus includes a liquid cooling type cooling device for cooling the developing device.

### SUMMARY

An image forming apparatus according to one aspect of the present disclosure includes a sheet storing portion for storing a sheet, a sheet conveying device, a printing device, and a cooling device. The sheet conveying device conveys the sheet stored in the sheet storing portion along a sheet conveying path. The printing device is disposed above the sheet storing portion and forms an image on the sheet conveyed by the sheet conveying device. The cooling device cools a cooling target that is a part of the printing device. The cooling device includes at least one heat exchange unit, a pump unit, and a heat exchange area tray. The heat exchange unit is disposed adjacent to the cooling target and exchanges heat between the cooling target and refrigerant liquid. The pump unit is disposed apart from the heat exchange unit and includes a pump for circulating the refrigerant liquid between the pump and the heat exchange unit and a radiator for radiating heat of the refrigerant liquid. The heat exchange area tray is disposed in an area spanning the entire heat exchange unit in plan view between the sheet storing portion and the heat exchange unit, and is capable of receiving liquid falling from above.

This Summary is provided to introduce a selection of concepts in a simplified form that are further described below in the Detailed Description with reference where appropriate to the accompanying drawings. This Summary is not intended to identify key features or essential features of the claimed subject matter, nor is it intended to be used to limit the scope of the claimed subject matter. Furthermore, the claimed subject matter is not limited to implementations that solve any or all disadvantages noted in any part of this disclosure.

### BRIEF DESCRIPTION OF THE DRAWINGS

FIG. 1 is a configuration diagram of an image forming apparatus according to an embodiment.
FIG. 2 is a perspective view of a pump unit of a cooling device in the image forming apparatus according to the embodiment.
FIG. 3 is a perspective view showing a positional relationship among a sheet storing portion, a printing device, and the cooling device in the image forming apparatus according to the embodiment.
FIG. 4 is a perspective view of a heat exchange area tray in the image forming apparatus according to the embodiment.

### DETAILED DESCRIPTION

Hereinafter, an embodiment of the present disclosure will be described with reference to the drawings. It is noted that the following embodiment is an example of embodying the present disclosure and does not limit the technical scope of the present disclosure.

### [First Embodiment]

An image forming apparatus 10 according to the embodiment is capable of executing a printing process of forming an image on a sheet 9. The sheet 9 is an image forming medium such as paper or a sheet-like resin member.

### [Configuration of Image Forming Apparatus 10]

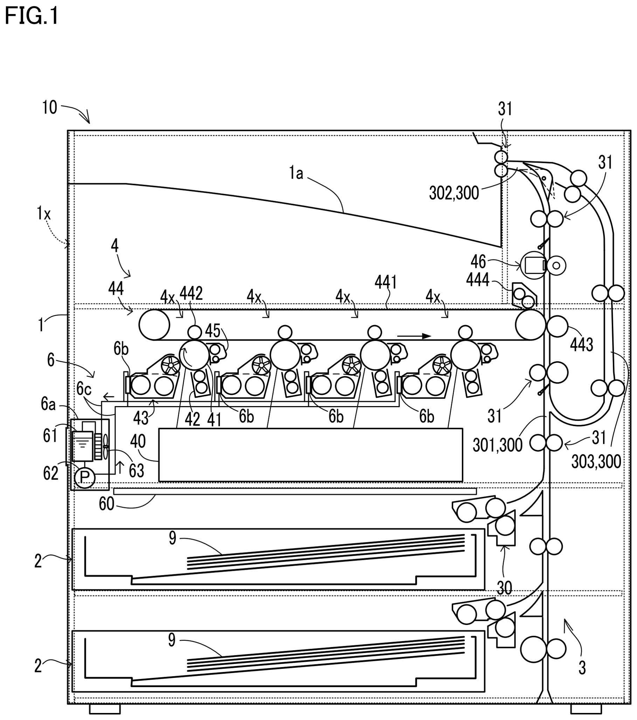

As shown in FIG. 1, the image forming apparatus 10 includes a sheet storing portion 2, a sheet conveying device 3, a printing device 4, and a cooling device 6. The image forming apparatus 10 further includes a main housing 1 that houses the sheet storing portion 2, the sheet conveying device 3, the printing device 4, and the cooling device 6.

The main housing 1 includes a main body frame 1x forming the framework of the main housing 1, and a sheet metal member and an exterior member (not shown) attached to the main body frame 1x.

The sheet storing portion 2 can store the sheet 9. For example, the sheet storing portion 2 is a sheet cassette which is installed in the main housing 1 so that it can be pulled out thereof.

The sheet conveying device 3 conveys the sheet 9 stored in the sheet storing portion 2 along a sheet conveying path 300. The sheet conveying path 300 is a conveying path of the sheet 9 disposed in the main housing 1.

The sheet conveying path 300 includes a main conveying path 301, a discharge conveying path 302, and a reverse conveying path 303. The main conveying path 301 is formed along the up-down direction starting from a position along the sheet storing portion 2.

The discharge conveying path 302 is connected to an upper end of the main conveying path 301, and forms a terminal end of the sheet conveying path 300. The reverse conveying path 303 branches from a portion of the main conveying path 301 connected to the discharge conveying path 302, and merges with the main conveying path 301.

The sheet conveying device 3 includes a sheet feeding mechanism 30 and a plurality of conveying roller pairs 31. The sheet feeding mechanism 30 feeds the sheet 9 stored in the sheet storing portion 2 to the main conveying path 301.

The plurality of conveying roller pairs 31 are rotated by being driven by a motor (not shown). The plurality of conveying roller pairs 31 convey the sheet 9 along the sheet conveying path 300. The plurality of conveying roller pairs 31 execute a first conveying process or a second conveying process.

The first conveying process is a process of conveying the sheet 9 along the main conveying path 301 and the discharge conveying path 302, and further discharging the sheet 9 from the discharge conveying path 302 to a discharge tray 1a. The second conveying process is a process of conveying the sheet 9 along the main conveying path 301 and the discharge conveying path 302, further conveying the sheet 9 from the discharge conveying path 302 to the reverse conveying path 303, further conveying the sheet 9 along the main conveying path 301 and the discharge conveying path 302 again, and further discharging the sheet 9 from the discharge conveying path 302 to the discharge tray 1a.

The printing device 4 executes the printing process on the sheet 9 conveyed along the main conveying path 301.

In the present embodiment, the printing device 4 executes the printing process using an electrophotographic method. The printing device 4 includes one or more image forming units 4x, a laser scanning unit 40, a transfer device 44, and a fixing device 46.

In the example shown in FIG. 1, the image forming apparatus 10 is a tandem-type color image forming apparatus. Therefore, the printing device 4 includes a plurality of image forming units 4x corresponding to a plurality of developing colors.

The image forming units 4x each include a drum-shaped photoconductor 41, a charging device 42, a developing device 43, a drum cleaning device 45, and the like. That is, the printing device 4 includes a plurality of photoconductors 41, a plurality of developing devices 43, and a plurality of drum cleaning devices 45 corresponding to a plurality of developing colors. The plurality of developing devices 43 are disposed adjacent to the plurality of photoconductors 41, respectively. The plurality of drum cleaning devices 45 are also disposed adjacent to the plurality of photoconductors 41, respectively.

In each of the image forming units 4x, the photoconductor 41 rotates, and the charging device 42 charges the surface of the photoconductor 41. The laser scanning unit 40 forms an electrostatic latent image on the surface of each of the photoconductors 41 by scanning the surface of the charged photoconductor 41 with a light beam. The laser scanning unit 40 is disposed below the plurality of photoconductors 41.

The developing devices 43 supply toner to the surfaces of the respective photoconductors 41 to develop the electrostatic latent images into toner images. The toner is a granular developer. The photoconductor 41 is an example of an image carrier that rotates while carrying the toner image.

In the present embodiment, the printing device 4 includes four image forming units 4x corresponding to the toners of four developing colors: yellow, cyan, magenta, and black. Accordingly, the printing device 4 includes four photoconductors 41, four developing devices 43, and four drum cleaning devices 45.

Four toner images are formed on the surfaces of the four photoconductors 41. The transfer device 44 transfers the toner images formed on the surfaces of the four photoconductors 41 onto the sheet 9 conveyed along the main conveying path 301. In the present embodiment, the transfer device 44 is disposed above the four photoconductors 41.

In the present embodiment, the transfer device 44 includes an intermediate transfer belt 441, four primary transfer devices 442 corresponding to the four image forming units 4x, a secondary transfer device 443, and a belt cleaning device 444.

The four primary transfer devices 442 transfer the toner images on the surfaces of the four photoconductors 41 to the surface of the intermediate transfer belt 441. Thus, a composite color toner image obtained by combining the toner images of the four photoconductors 41 is formed on the surface of the intermediate transfer belt 441.

The secondary transfer device 443 transfers the color toner image formed on the intermediate transfer belt 441 to the sheet 9 at a transfer position of the main conveying path 301.

The fixing device 46 is disposed at a fixing position of the main conveying path 301. The fixing position is a position downstream of the transfer position in the sheet conveying direction. The fixing device 46 heats and presses the color toner image transferred to the sheet 9. Thus, the fixing device 46 fixes the color toner image on the sheet 9.

The drum cleaning devices 45 remove waste toner remaining on the surfaces of the respective photoconductors 41. The belt cleaning device 444 removes waste toner remaining on the intermediate transfer belt 441.

The image forming apparatus 10 further includes a liquid cooling type cooling device 6 for cooling a cooling target, which is a part of the printing device 4.

By the way, in the liquid cooling type cooling device 6, a pump 62 circulates refrigerant liquid through one or more heat exchange units 6b and a radiator 63 (see FIG. 1). The pump 62, the heat exchange unit 6b, and the radiator 63 are connected by a plurality of tubes 6c (see FIG. 1).

In the image forming apparatus 10, when the refrigerant liquid leaks from a connecting portion of the apparatus, the refrigerant liquid may stain the sheet 9 stored in the sheet storing portion 2.

The image forming apparatus 10 is provided with a structure for preventing the refrigerant liquid leaking from the liquid cooling type cooling device 6 from staining the sheet 9 stored in the sheet storing portion 2. Hereinafter, a configuration of the cooling device 6 will be described.

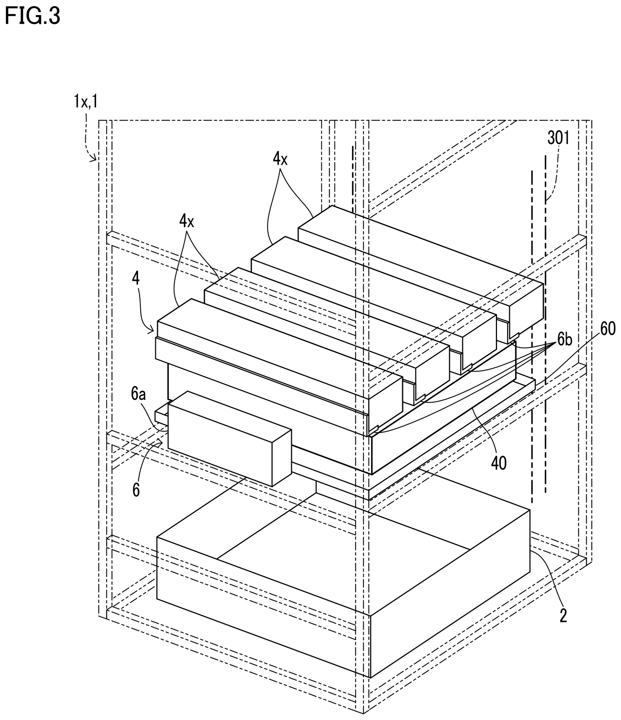

The cooling device 6 includes a pump unit 6a, one or more heat exchange units 6b disposed adjacent to the cooling target, and a plurality of tubes 6c (see FIG. 1 and FIG. 3).

The heat exchange unit 6b exchanges heat between the refrigerant liquid and the cooling target. Thus, the heat exchange unit 6b cools the cooling target, the temperature of which is higher than that of the refrigerant liquid.

In the image forming apparatus 10, toner stored in each of the developing devices 43 may become hot due to frictional heat generated by stirring of the toner. When the toner temperature rises, the softened toner may agglomerate, resulting in poor image quality.

The cooling target in the image forming apparatus 10 is the plurality of developing devices 43 in the plurality of image forming units 4x. In this case, the cooling device 6 includes a plurality of heat exchange units 6b disposed adjacent to the plurality of developing devices 43 (see FIG. 1). In the present embodiment, the cooling device 6 includes four heat exchange units 6b corresponding to four developing devices 43.

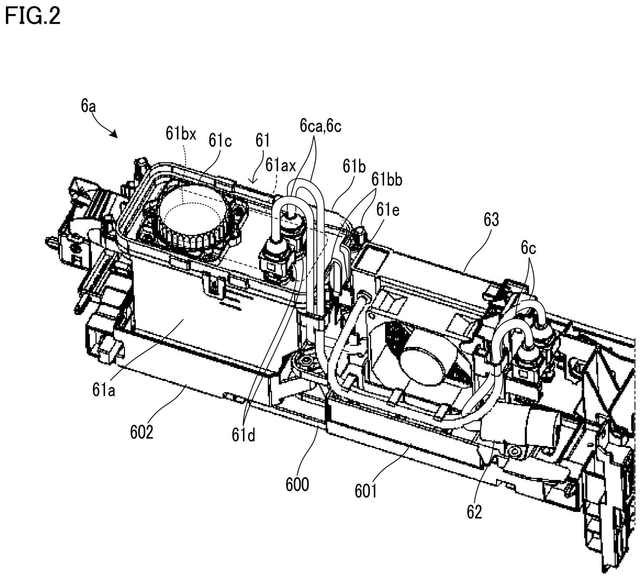

The pump unit 6a includes a support base 600, a pump tray 601, a tank support 602, a tank 61, a pump 62, and a radiator 63 (see FIG. 2).

The tank 61 stores the refrigerant liquid. The tank 61 has a cap 61c that closes a supply hole 61bx communicating with the inside of the tank 61 (see FIG. 3). The cap 61c can open and close the supply hole 61bx formed in the upper surface of the tank 61. In the present embodiment, the cap 61c is a screw cap.

The pump 62 circulates the refrigerant liquid through the tank 61, the plurality of heat exchange units 6b, and the radiator 63. The tank 61, the pump 62, the plurality of heat exchange units 6b, and the radiator 63 are connected by the plurality of tubes 6c. The plurality of tubes 6c form a circulation path of the refrigerant liquid.

The support base 600 supports the pump tray 601 and the tank support 602. The pump tray 601 is disposed adjacent to the tank 61. The pump 62 and the radiator 63 are disposed on the pump tray 601. The pump tray 601 can receive liquid falling from the pump 62 and the radiator 63.

In the pump tray 601, the outer edge portion is an annular protruding portion protruding upward from an inner portion of the outer edge portion. Thus, the pump tray 601 can receive the liquid in the inner portion of the outer edge portion.

When the refrigerant liquid leaks from the pump 62 or the radiator 63, the leaked refrigerant liquid accumulates in the pump tray 601. The same applies to a case where the refrigerant liquid leaks from a portion of the plurality of tubes 6c connected to the pump 62 or the radiator 63.

The radiator 63 radiates the heat of the refrigerant liquid the temperature of which has increased by heat exchange with the four developing devices 43. In the example shown in FIG. 2, the radiator 63 is an air-cooling device having a cooling fan.

The tank support 602 supports the tank 61. The plurality of tubes 6c include a pair of specific tubes 6ca forming an inflow path of the refrigerant liquid to the tank 61 and an outflow path of the refrigerant liquid from the tank 61 (see FIG. 3).

The tank 61 has a tube fixing portion 61d (see FIG. 3). The tube fixing portion 61d is a portion for fixing a portion of the pair of specific tubes 6ca to the upper surface of the tank 61 in a state where the pair of specific tubes 6ca penetrate the upper surface of the tank 61. The tube fixing portion 61d is a portion for connecting the pair of specific tubes 6ca to the tank 61.

The tank 61 further includes an upper surface tray 61b and a liquid discharge portion 61e (see FIG. 2). The upper surface tray 61b forms an upper surface of the tank 61 at a position higher than the pump tray 601.

A supply hole 61bx is formed in the upper surface tray 61b. A cap 61c is detachably attached to the upper surface tray 61b. The cap 61c closes the supply hole 61bx by being attached to the upper surface tray 61b.

In the upper surface tray 61b, the outer edge portion is an annular protruding portion protruding upward from an inner portion of the outer edge portion. Thus, the upper surface tray 61b can receive the liquid in the inner portion of the outer edge portion.

The upper surface tray 61b can store a smaller amount of liquid than the pump tray 601. In other words, the pump tray 601 can store a larger amount of liquid than the upper surface tray 61b.

The tube fixing portion 61d fixes a part of the pair of specific tubes 6ca to the upper surface tray 61b in a state where the pair of specific tubes 6ca penetrate the upper surface tray 61b (see FIG. 2).

The liquid discharge portion 61e is formed at the edge of the upper surface tray 61b, and forms a liquid discharge path from the upper surface tray 61b to the pump tray 601.

When the refrigerant liquid leaks from the tube fixing portion 61d, the leaked refrigerant liquid is temporarily stored in the upper surface tray 61b and then flows to the pump tray 601 through the liquid discharge portion 61e.

In the example shown in FIG. 2, the tank 61 has a tank body 61a and an upper surface tray 61b. The tank body 61a stores the refrigerant liquid, and has a body opening 61ax that is open at the top (see FIG. 2). The upper surface tray 61b is attached to the tank body 61a and closes the body opening 61ax.

The cooling device 6 further includes a heat exchange area tray 60 for receiving the refrigerant liquid leaking from the plurality of heat exchange units 6b (see FIG. 1 and FIG. 3).

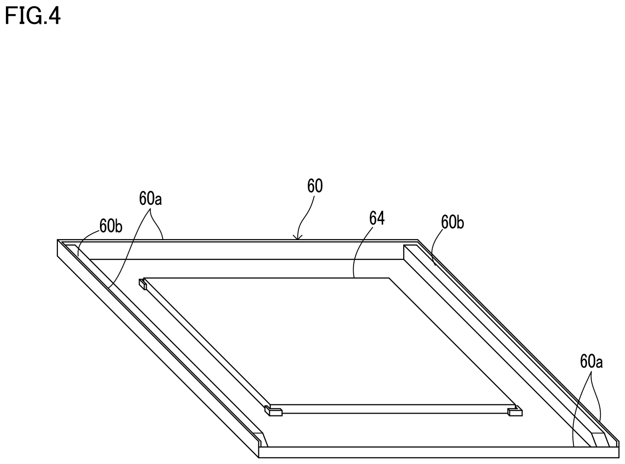

The outer edge portion 60a of the heat exchange area tray 60 is an annular protruding portion protruding upward from an inner portion of the outer edge portion 60a (see FIG. 4). As a result, the heat exchange area tray 60 can receive the liquid in the inner portion of the outer edge portion 60a.

FIG. 3 shows a positional relationship among the sheet storing portion 2, the plurality of image forming units 4x of the printing device 4, and the cooling device 6.

The heat exchange area tray 60 is disposed in an area spanning the entire plurality of heat exchange units 6b in plan view, between the sheet storing portion 2 and the plurality of heat exchange units 6b (see FIG. 3). The heat exchange area tray 60 can receive liquid falling from above.

By employing the heat exchange area tray 60, the sheet 9 stored in the sheet storing portion 2 is prevented from being stained by the refrigerant liquid leaking from the plurality of heat exchange units 6b of the cooling device 6.

In the present embodiment, the heat exchange area tray 60 is disposed between the sheet storing portion 2 and the laser scanning unit 40 (see FIG. 3). The heat exchange area tray 60 is disposed in an area spanning the entire plurality of heat exchange units 6b and the entire laser scanning unit 40 in plan view.

Therefore, even when the refrigerant liquid leaking from the plurality of heat exchange units 6b falls along the laser scanning unit 40, the heat exchange area tray 60 can receive the refrigerant liquid falling from the laser scanning unit 40.

The pump unit 6a is disposed apart from the plurality of heat exchange units 6b. In the present embodiment, the pump unit 6a is disposed in an area outside the heat exchange area tray 60 in plan view. For example, the pump unit 6a is disposed in an area that does not overlap with the plurality of heat exchange units 6b and the heat exchange area tray 60 in plan view.

When the refrigerant liquid leaks from the pump 62, the radiator 63, and the tube fixing portion 61d of the tank 61, the leaked refrigerant liquid accumulates in the pump tray 601. As a result, the sheet 9 stored in the sheet storing portion 2 can be prevented from being stained with the refrigerant liquid that has leaked from the pump unit 6a.

In the present embodiment, the heat exchange area tray 60 includes a unit guide 60b (see FIG. 4). The unit guide 60b guides the laser scanning unit 40 to a target position in the main housing 1 when the laser scanning unit 40 is inserted into the main housing 1. The target position is a position below the plurality of photoconductors 41.

After the laser scanning unit 40 is inserted into the target position in the main housing 1, the laser scanning unit 40 is fixed to a mounting portion of the main body frame 1x.

The main conveying path 301 is formed along the up-down direction in an area outside the heat exchange area tray 60 in plan view (see FIG. 1 and FIG. 3). The reverse conveying path 303 is also formed in an area outside the heat exchange area tray 60 in plan view.

For example, the main conveying path 301 and the reverse conveying path 303 are disposed in an area that does not overlap with the plurality of heat exchange units 6b and the heat exchange area tray 60 in plan view. As a result, the refrigerant liquid leaking from the plurality of heat exchange units 6b is prevented from contaminating the main conveying path 301 and the reverse conveying path 303.

Further, the cooling device 6 includes a liquid absorbing member 64 disposed on the heat exchange area tray 60 and capable of absorbing liquid (see FIG. 4). For example, the liquid absorbing member 64 is a sponge or the like.

The liquid absorbing member 64 prevents the refrigerant liquid from spilling out of the heat exchange area tray 60 when the image forming apparatus 10 is shaken.

For example, the heat exchange area tray 60 may be supported by the main body frame 1x so that it can be pulled out from inside the main housing 1. In this case, the liquid absorbing member 64 prevents the refrigerant liquid from spilling out of the heat exchange area tray 60 when the heat exchange area tray 60 is pulled out.

### [First Modification]

The cooling target of the cooling device 6 may include devices other than the developing device 43 in the image forming apparatus 10. For example, the plurality of heat exchange units 6b may be disposed adjacent to the plurality of developing devices 43 and the laser scanning unit 40.

### [Second Modification]

The cooling device 6 may be applied to an ink jet image forming apparatus. For example, the cooling device 6 may cool the inkjet head.

It is to be understood that the embodiments herein are illustrative and not restrictive, since the scope of the disclosure is defined by the appended claims rather than by the description preceding them, and all changes that fall within metes and bounds of the claims, or equivalence of such metes and bounds thereof are therefore intended to be embraced by the claims.

## Claims

1. An image forming apparatus (10) comprising:
a sheet storing portion (2) configured to store a sheet;
a sheet conveying device (3) configured to convey the sheet stored in the sheet storing portion (2) along a sheet conveying path (300);
a printing device (4) disposed above the sheet storing portion (2) and configured to form an image on the sheet conveyed by the sheet conveying device (3); and
that is a part of the printing device (4), wherein
the cooling device (6) includes:
at least one heat exchange unit (6b) disposed adjacent to the cooling target and configured to exchange heat between the cooling target and refrigerant liquid;
a pump unit (6a) disposed apart from the heat exchange unit (6b) and including a pump (62) for circulating the refrigerant liquid between the pump (62) and the heat exchange unit (6b) and a radiator (63) for radiating heat of the refrigerant liquid; and
a heat exchange area tray (60) disposed in an area spanning the entire heat exchange unit (6b) in plan view between the sheet storing portion (2) and the heat exchange unit (6b), and capable of receiving liquid falling from above.

2. The image forming apparatus (10) according to claim 1, wherein the pump unit (6a) includes a pump tray (601) disposed in an area outside the heat exchange area tray (60) in plan view and capable of receiving liquid falling from the pump (62) and the radiator (63).

3. The image forming apparatus (10) according to claim 1 or 2, wherein the cooling device (6) includes a liquid absorbing member (64) disposed on the heat exchange area tray (60) and capable of absorbing liquid.

4. The image forming apparatus (10) according to any one of claims 1 to 3, wherein
the sheet conveying device (3) conveys the sheet stored in the sheet storing portion (2) along a main conveying path (301) formed along an up-down direction in an area outside the heat exchange area tray (60) in plan view, and
the printing device (4) forms an image on the sheet conveyed along the main conveying path (301).

5. The image forming apparatus (10) according to claim 4, wherein
the printing device (4) includes:
a plurality of photoconductors (41);
a laser scanning unit (40) disposed below the plurality of photoconductors (41) and configured to scan surfaces of the plurality of photoconductors (41) with a light beam to form electrostatic latent images on the surfaces of the plurality of photoconductors (41);
a plurality of developing devices (43) disposed adjacent to the plurality of photoconductors (41) and configured to develop the electrostatic latent images formed on the surfaces of the plurality of photoconductors (41) into toner images; and
photoconductors (41) and configured to transfer the toner images formed on the surfaces of the plurality of photoconductors (41) onto the sheet conveyed along the main conveying path (301),
the cooling target is the plurality of developing devices (43), and
the heat exchange area tray (60) is disposed between the sheet storing portion (2) and the laser scanning unit (40).

6. The image forming apparatus (10) according to claim 5, further comprising:
a main housing (1) configured to house the sheet storing portion (2), the sheet conveying device (3), the printing device (4), and the cooling device (6), wherein
the heat exchange area tray (60) includes a unit guide (60b) configured to guide the laser scanning unit (40) to a target position in the main housing (1) when the laser scanning unit (40) is inserted into the main housing (1).

7. The image forming apparatus (10) according to any one of claims 1 to 6, further comprising:
a main housing (1) configured to house the sheet storing portion (2), the sheet conveying device (3), the printing device (4), and the cooling device (6), wherein
the heat exchange area tray (60) is supported so as to be pulled out of the main housing (1).
